(19) Europäisches Patentamt
European Patent Office
Office européen des brevets

(11) Veröffentlichungsnummer : **0 101 976**
**B1**

(12) # EUROPÄISCHE PATENTSCHRIFT

(45) Veröffentlichungstag der Patentschrift : **21.01.87**

(51) Int. Cl.$^4$ : **G 03 F 7/10**, G 03 F 7/26

(21) Anmeldenummer : **83107688.0**

(22) Anmeldetag : **04.08.83**

(54) **Negativ arbeitendes Verfahren zur Herstellung von Reliefbildern oder Resistmustern.**

(30) Priorität : **21.08.82 DE 3231145**

(43) Veröffentlichungstag der Anmeldung : **07.03.84 Patentblatt 84/10**

(45) Bekanntmachung des Hinweises auf die Patenterteilung : **21.01.87 Patentblatt 87/04**

(84) Benannte Vertragsstaaten : **BE CH DE FR GB IT LI NL**

(56) Entgegenhaltungen :
**EP-A- 0 019 770**
**DE-A- 2 150 691**
**DE-A- 2 242 394**
**DE-A- 2 309 062**

(73) Patentinhaber : **BASF Aktiengesellschaft**
**Carl-Bosch-Strasse 38**
**D-6700 Ludwigshafen (DE)**

(72) Erfinder : **Klinsmann, Uwe, Dr.**
**Mollstrasse 39**
**D-6800 Mannheim 1 (DE)**
Erfinder : **Leyrer, Reinhold J., Dr.**
**Menzelstrasse 4**
**D-6700 Ludwigshafen (DE)**
Erfinder : **Saenger, Dietrich, Dr.**
**Lorcher Ring 16 a**
**D-6710 Frankenthal (DE)**

EP 0 101 976 B1

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein negativ arbeitendes Verfahren zur Herstellung von Reliefbildern, wie z. B. Offsetdruckplatten, oder Resistmustern auf einem Träger mittels eines lichtempfindlichen Aufzeichnungsmaterials mit einer auf dem Träger aufgebrachten lichtempfindlichen und nach der Belichtung härtbaren und vernetzbaren Resistschicht, die als lichtempfindliche Komponente eine Verbindung mit mindestens zwei aromatischen und/oder heteroaromatischen o-Nitrocarbinolestergruppierungen enthält. Zur Herstellung der Reliefbilder oder Resistmuster wird die lichtempfindliche Resistschicht bildmäßig mit aktinischem Licht belichtet, darauf werden die belichteten Bereiche der Resistschicht selektiv thermisch gehärtet und vernetzt und anschließend die unvernetzten Bereiche dieser Schicht mit einem Entwickler-Lösungsmittel ausgewaschen.

Es sind zahlreiche negativ arbeitende lichtempfindliche Aufzeichnungsmaterialien sowie Verfahren zur Bildherstellung mittels dieser Aufzeichnungsmaterialien bekannt. Unter negativ arbeitenden Aufzeichnungsmaterialien bzw. negativ arbeitenden Bildherstellungs-Verfahren werden dabei solche verstanden, bei denen nach der bildmäßigen Belichtung der lichtempfindlichen Schicht die belichteten Bereiche dieser Schicht in Lösungsmitteln unlöslich werden, in denen sie vorher löslich waren. Somit werden beim Entwickeln die unbelichteten Bereiche der lichtempfindlichen Schicht entfernt, und man erhält ein negatives Abbild der bildmäßigen Vorlage.

Im allgemeinen basieren negativ arbeitende Aufzeichnungsmaterialien auf fotopolymerisierbaren Gemischen, die neben einem polymeren Bindemittel eine fotopolymerisierbare Verbindung und einen Fotoinitiator enthalten. Bei Belichtung mit aktinischem Licht wird durch die fotoinitiierte Polymerisation in den belichteten Bereichen des Gemisches eine Vernetzung und damit eine Löslichkeitsdifferenzierung zu den unbelichteten Bereichen bewirkt. Bei dem in der DE-A-2 361 141 beschriebenen fotopolymerisierbaren Materialien kann die Polymerisation und Vernetzung durch Einwirkung von Wärme nach der Belichtung verstärkt werden, ohne daß hierbei die thermische Stabilität und Lagerfähigkeit der Materialien vor der Belichtung beeinträchtigt wird. Sofern die bekannten negativ arbeitenden fotopolymerisierbaren Aufzeichnungsmaterialien mit wäßrigen Entwicklerlösungsmitteln auswaschbar sein sollen, müssen polymere Bindemittel eingesetzt werden, die in wäßrigen Medien löslich sind, wodurch die Beständigkeit der hergestellten Reliefbilder oder Resistmuster gegenüber wäßrigen Medien, insbesondere Laugen oder Säuren, für viele Anwendungsgebiete unzureichend ist.

Aus der DE-B2-2 309 062 ist bekannt, aus lichtempfindlichen Schichten, die eine aromatische o-Nitrocarbinolestergruppierungen aufweisende Verbindung und zusätzlich ein Epoxiharzpräpolymeres enthalten, Reliefbilder oder Resistmuster herzustellen, indem man die lichtempfindliche Schicht bildmäßig belichtet, durch eine Wärmebehandlung in der belichteten Schicht das durch die Belichtung hervorgerufene latente Bild selektiv härtet und anschließend die unbelichteten, ungehärteten Schichtanteile mit einem Lösungsmittel entfernt. Dieses ebenfalls negativ arbeitende Verfahren bedarf jedoch in aller Regel organischer Lösungsmittel zur Entwicklung der belichteten und selektiv gehärteten Schicht. Um die Entwicklung in wäßrigen Lösungsmitteln vornehmen zu können, müssen in diesem Verfahren o-Nitrocarbinolestergruppierungen tragende Verbindungen eingesetzt werden, die als solche bereits wasserlöslich sind. In diesem Fall besitzen jedoch die hergestellten Reliefbilder oder Resistmuster auch nicht die gewünschte und geforderte Beständigkeit gegenüber den bei der Weiterverarbeitung verwendeten Prozeßchemikalien, insbesondere starken Laugen oder Säuren, wie sie z. B. in Galvano- oder Ätzbädern zur Anwendung gelangen. Das gleiche gilt für die Festigkeit solcher Schichten bei Anwendung für Offsetdruckplatten, die hohe Auflagen nicht zulassen.

In der DE-A-2 150 691 sowie der DE-A-2 922 746 werden Aufzeichnungsmaterialien für die Herstellung von Reliefbildern oder Resistmustern beschrieben, deren lichtempfindliche Schicht auf Basis von o-Nitrocarbinolestergruppierungen enthaltenden Polymeren aufgebaut ist, die nach der Belichtung mit einem wäßrig-alkalischen Lösungsmittel ausgewaschen werden können. Diese bekannten Beschichtungsmaterialien, die sich für die Herstellung von Resistschichten oder Flachdruckplatten eignen, sind jedoch positiv arbeitend und darüber hinaus auch bezüglich ihrer Temperaturstabilität nach dem Belichten und Entwickeln sowie ihrer Resistenz gegenüber starken und aggressiven Säuren und Laugen weiter verbesserungsbedürftig.

Schließlich sind in der DE-A 2 242 394 unter Lichteinwirkung härtbare Mischungen aus einer aromatische oder heteroaromatische o-Nitrocarbinolestergruppierungen tragenden Verbindung und Aziridin- oder Isocyanatgruppen enthaltenden Verbindungen beschrieben. Diese lichthärtbaren Gemische werden gemäß der Lehre der DE-A-2 242 394 zur Herstellung von Formkörpern, Imprägnierungen, Beschichtungen, Überzügen, Druckfarben etc. eingesetzt. Hierzu werden die aus diesen Gemischen hergestellten lichtempfindlichen Schichten und Überzüge vollflächig belichtet und durchgehärtet. Auch die Herstellung von Druckplatten für den Buch- und Offsetdruck ist in dieser Druckschrift angesprochen.

Aufgabe der vorliegenden Erfindung ist es, ein negativ arbeitendes Verfahren zur Herstellung von Reliefbildern, wie Offsetdruckplatten, oder Resistmustern mittels eines Aufzeichnungsmaterials mit einer lichtempfindlichen Resistschicht aufzuzeigen, bei welchem die belichtete Resistschicht mit wäßrigen Entwicklerlösungsmitteln ausgewaschen werden kann, die hergestellten Reliefbilder oder Resistmuster aber dennoch eine verbesserte Resistenz gegenüber wäßrigen Medien, insbesondere den in Galvano-oder Ätzbädern zur Anwendung gelangenden starken Laugen oder Säuren, sowie darüber hinaus gute Haftfestigkeiten auf dem Träger, gute thermische Stabilität, hohe mechanische Festigkeit und gute isolatorische Eigenschaften, wie Kriechstrom- und Durchschlagsfestigkeit, besitzen. Das Verfahren soll einfach durchführbar, variabel und breit anwendbar sein und insbesondere bei hoher Auflösung die Herstellung von exakten und vorlagengetreuen Reliefbildern oder Resistmustern ermöglichen.

Es wurde nun überraschenderweise gefunden, daß diese Aufgabe gelöst wird, wenn man von einem lichtempfindlichen Aufzeichnungsmaterial ausgeht, dessen lichtempfindliche Schicht eine Verbindung mit mindestens zwei aromatischen und/oder heteroaromatischen o-Nitrocarbinolestergruppierungen und eine vernetzend wirkende Verbindung mit mindestens zwei reaktiven Gruppen enthält, die mit COOH-Gruppen unter Bildung einer kovalenten chemischen Bindung zu reagieren vermögen, wobei man diese lichtempfindliche Schicht bildmäßig mit aktinischem Licht belichtet, darauf die belichteten Bereiche der Schicht selektiv thermisch härtet und vernetzt, anschließend die Schicht vollflächig mit aktinischem Licht nachbelichtet und schließlich mit einem wäßrigen Entwickler-Lösungsmittel auswäscht.

Gegenstand der Erfindung ist demzufolge ein Verfahren zur Herstellung von Reliefbildern oder Resistmustern, die ein negatives Abbild einer bildmäßigen Vorlage darstellen, bei dem eine auf einem Träger aufgebrachte lichtempfindliche und nach der Belichtung vernetzbare Resistschicht, die als lichtempfindliche Komponente eine Verbindung mit mindestens zwei aromatischen und/oder heteroaromatischen o-Nitrocarbinolestergruppierungen der allgemeinen Formel (I)

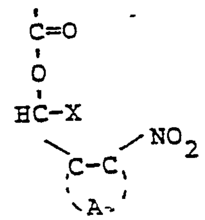

(I)

enthält, worin A den Rest eines aromatischen oder heteroaromatischen, gegebenenfalls substituierten Ringsystems mit 5 bis 14 Ringgliedern und X ein Wasserstoffatom, einen Alkylrest mit 1 bis 8 Kohlenstoffatomen oder einen gegebenenfalls substituierten Aryl- oder Aralkylrest bedeuten, und als vernetzend wirkende Verbindung eine Verbindung mit mindestens zwei reaktiven Gruppen enthält, die unter dem Einfluß von Wärme mit —COOH-Gruppen unter Bildung einer kovalenten chemischen Bindung zu reagieren vermögen, mit aktinischem Licht bildmäßig belichtet wird, darauf die belichteten Bereiche der Resistschicht selektiv thermisch gehärtet und vernetzt und anschließend die unvernetzten Bereiche der Resistschicht mit einem Entwicklerlösungsmittel ausgewaschen werden. Das Verfahren ist dadurch gekennzeichnet, daß die Resistschicht nach dem bildmäßigen Belichten und selektiven thermischen Härten und Vernetzen der belichteten Bereiche noch einmal vollflächig mit aktinischem Licht nachbelichtet und anschließend mit einem wäßrigen Entwickler-Lösungsmittel ausgewaschen wird.

Es war höchst überraschend und in keiner Weise vorhersehbar, daß trotz der vollflächigen Nachbelichtung der bildmäßig belichteten und selektiv gehärteten Resistschicht die Beständigkeit der erzeugten Reliefbilder oder Resistmuster gegenüber wäßrigen Medien sehr hoch ist. So kann die Entwicklung der bildmäßig belichteten Resistschicht ohne Beeinträchtigung der Reliefstruktur mit wäßrigen Lösungsmitteln durchgeführt werden. Das erfindungsgemäße Verfahren führt zu Reliefbildern und Resistmustern, die gegenüber wäßrigen Behandlungsmitteln, insbesondere starken Laugen oder Säuren, wie sie in Galvano- oder Ätzbädern verwendet werden, sehr stabil sind. Die erhaltenen Reliefbildern oder Resistmuster besitzen eine gute thermische Stabilität, d. h. sie haben auch bei höheren Temperaturen, z. B. über 100 °C, noch sehr gute mechanische Festigkeiten. Sie haben darüber hinaus hohe Kriechstrom- und Durchschlagsfestigkeiten, die sie insbesondere zur Anwendung bei der Herstellung von gedruckten Schaltungen als Lötstoppmasken geeignet machen. Mit dem erfindungsgemäßen Verfahren können sogar sehr feine Bildelemente, wie Linien, Striche oder Punkte, vorlagengetreu und genau reproduziert werden, wobei sich das Verfahren auch für die Reproduktion in dünnen Schichten eignet. Ein besonderer Vorteil des erfindungsgemäßen Verfahrens besteht darin, daß sich über die Art und Menge der in der lichtempfindlichen Schicht enthaltenen vernetzend wirkenden Verbindungen sowie über die bei der Härtung und Vernetzung angewandte Temperatur als auch gegebenenfalls eine Nachvernetzung nach dem Auswaschen mit dem wäßrigen Entwicklerlösungsmittel der Härtungs- und Vernetzungsgrad und damit die Schichteigenschaften kontinuierlich je nach dem anschließenden Verwendungszweck einstellen lassen.

Die hohe Abriebfestigkeit der hergestellten Bildelemente gestattet die Herstellung besonders auflagenstarker Flachdruckplatten.

Bei der Durchführung des erfindungsgemäßen Verfahrens wird ein lichtempfindliches Aufzeichnungsmaterial mit einer auf einem Träger aufgebrachten lichtempfindlichen Resistschicht eingesetzt. Die Wahl des Trägers richtet sich dabei nach dem Anwendungszweck der herzustellenden Reliefbilder oder Resistmuster. Als Träger kommen beispielsweise metallische, metalloxidische oder keramische Untergründe, aber auch Filme, Folien oder Platten aus polymeren Substanzen in Betracht. So werden

beispielsweise für die Herstellung von Ätz- oder Galvanomustern als Träger Kupferbleche oder kupferkaschierte Substrate verwendet. Für die Herstellung von Dünnschichtschaltungen werden als Trägermaterial insbesondere Keramiksubstrate, die mit metallischen oder metalloxidischen Schichten beschichtet sind, oder Halbleiterelemente verarbeitet. Zur Herstellung von Reliefbildern, insbesondere Offset-Druckplatten, können als Träger Metalle, z. B. Stahl- oder Aluminium-Bleche, die mechanisch oder elektrochemisch aufgerauht sind und/oder eine anodisch erzeugte Oxidschicht besitzen, oder Kunststoffolien, z. B. aus Polyestern, die auch metallisch bedampft sein können, zur Anwendung gelangen. Für die Herstellung einer Lötstoppmaske kann die lichtempfindliche Resistschicht z. B. auf das Schaltbild einer gedruckten Schaltung als Träger aufgebracht werden. Die lichtempfindliche Resistschicht kann auf das Trägermaterial nach den bekannten Auftragstechniken entweder aus Lösung, z. B. durch spincoating, Gießen, Tauchbeschichtung etc., oder trocken nach den gebräuchlichen Laminierverfahren aufgebracht werden.

In dem erfindungsgemäßen Verfahren werden solche lichtempfindliche Resistschichten eingesetzt, die als lichtempfindliche Komponente eine Verbindung mit mindestens zwei aromatischen und/oder heteroaromatischen o-Nitrocarbinolestergruppierungen der allgemeinen Formel (I)

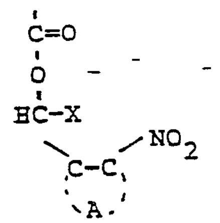

(I)

enthalten, worin A den Rest eines aromatischen oder heteroaromatischen, gegebenenfalls substituierten Ringsystems mit 5 bis 14 Ringgliedern und X ein Wasserstoffatom, einen Alkylrest mit 1 bis 8 C-Atomen oder einen gegebenenfalls substituierten Aryl- oder Aralkylrest bedeuten.

Das aromatische oder heteroaromatische Ringsystem A mit der o-ständigen Nitrogruppe kann ein- oder mehrkernig sein. Unter den aromatischen Ringsystemen ist insbesondere das Benzol bevorzugt, wobei der Benzolring ein- oder mehrfach substituiert sein kann, beispielsweise durch $C_1$-$C_8$-Alkyl, insbesondere Methyl, durch $C_1$-$C_6$-Alkoxy, insbesondere Methoxy, durch Halogen, wie Chlor oder Brom, durch Nitro-, Amino-, Monomethylamino-, Dimethylamino-, Nitril- oder Sulfogruppen. Als mehrkernige aromatische Ringsysteme kommen z. B. Naphthalin, Anthracen, Anthrachinon, Phenanthren oder die entsprechenden substituierten Derivate in Betracht. Als heteroaromatisches Ringsystem ist der Pyridinrest bevorzugt. X ist insbesondere ein Wasserstoffatom, der Methyl- oder Ethylrest oder der gegebenenfalls substituierte Phenylrest.

Beispiele für besonders bevorzugte aromatische oder heteroaromatische o-Nitrocarbinole, die den o-Nitrocarbinolestergruppierungen der allgemeinen Formel (I) zugrunde liegen, sind o-Nitrobenzylalkohol, 2-Nitro-6-chlor-benzylalkohol, 2-Nitro-4-cyanobenzylalkohol, 2-Nitro-4,5-dimethoxybenzylalkohol, alpha-Methyl-o-nitrobenzylalkohol, alpha-Phenyl-o-nitrobenzylalkohol, alpha-(o-Nitrophenyl)-o-nitrobenzylalkohol und 2-Nitro-3-hydroxymethylpyridin.

Als Verbindung mit den aromatischen und/oder heteroaromatischen o-Nitrocarbinolestergruppierungen kommen niedermolekulare Ester mit zwei oder mehr der Estergruppierungen der allgemeinen Formel (I) in Betracht. Hierzu gehören insbesondere die Di- und/oder Polyester von niedermolekularen Di- und/oder Polycarbonsäuren mit aromatischen und/oder heteroaromatischen o-Nitrocarbinolen der in Rede stehenden Art. Beispiele für niedermolekulare Di- und Polycarbonsäuren, die solchen Estern zugrunde liegen können, sind Oxalsäure, Malonsäure, Adipinsäure, Maleinsäure, Fumarsäure, Terephthalsäure, Trimellithsäure und Trimesinsäure.

Werden als lichtempfindliche Komponente niedermolekulare o-Nitrocarbinolestergruppierungen enthaltende Verbindungen eingesetzt, so enthält die lichtempfindliche Resistschicht vorteilhaft noch ein mit diesen Estern verträgliches polymeres Bindemittel, wobei sich hierfür z. B. Acrylat- und/oder Methacrylat-Polymere besonders bewährt haben. Als polymere Bindemittel für die lichtempfindliche Resistschicht kommen auch die nachfolgend beschriebenen hochmolekularen vernetzend wirkenden Verbindungen mit gegenüber Carboxylgruppen reaktiven Gruppen in Betracht. Im Falle des Einsatzes von niedermolekularen o-Nitrocarbinolestergruppierungen enthaltenden Verbindungen als lichtempfindlicher Komponente wird deren Menge in der lichtempfindlichen Resistschicht so bemessen, daß der angestrebte Härtungs- und Vernetzungsgrad der bildmäßig belichteten Resistschicht erreicht wird und die Resistschicht nach der vollflächigen Nachbelichtung mit den wäßrigen Entwickler-Lösungsmitteln auswaschbar ist. Hierzu ist es im allgemeinen hinreichend, wenn in der lichtempfindlichen Resistschicht 2 bis 30 Gewichtsprozent, insbesondere 10 bis 15 Gewichtsprozent der niedermolekularen Verbindung mit den aromatischen und/oder heteroaromatischen o-Nitrocarbinolestergruppierungen der Formel (I), berechnet als —COO—, bezogen auf die gesamte lichtempfindliche Resistschicht, enthalten sind.

Besonders bewährt haben sich in dem erfindungsgemäßen Verfahren lichtempfindliche Resistschichten, die als lichtempfindliche Komponente ein Polymeres mit einem Molekulargewicht > 500 enthalten,

welches mindestens 5 Gewichtsprozent, bezogen auf das Molekulargewicht des Polymeren, aromatische und/oder heteroaromatische o-Nitrocarbinolestergruppierungen der allgemeinen Formel (I) im Molekül gebunden enthält. Bezüglich dieser Polymeren mit den o-Nitrocarbinolestergruppierungen sowie deren Herstellung sei insbesondere auf die Angaben in der eingangs zitierten DE-A-2 150 691 verwiesen. Als das die o-Nitrocarbinolestergruppierungen tragende Polymer kommt zweckmäßigerweise eine organische Polycarbonsäure in Betracht, deren Carboxylgruppen mit den aromatischen und/oder heteroaromatischen o-Nitrocarbinolen verestert sind. Bei den organischen Polycarbonsäuren handelt es sich im allgemeinen um Homopolymere oder Copolymere von ethylenisch ungesättigten Mono- oder Dicarbonsäuren mit 3 bis 6 Kohlenstoffatomen, insbesondere um Homo- oder Copolymerisate von Acrylsäure, Methacrylsäure, Maleinsäure, Fumarsäure oder Crotonsäure. Als Comonomeren kommt dabei Ethylen, Styrol und den $C_1$-$C_8$-Alkylestern der obengenannten ethylenisch ungesättigten Carbonsäuren besondere Bedeutung zu.

Es sei darauf hingewiesen, daß praktisch alle Carboxylgruppen der die o-Nitrocarbinolestergruppierungen tragenden Polycarbonsäure verestert sein oder zumindest in einer Form vorliegen müssen, die mit den reaktiven Gruppen der nachfolgend beschriebenen vernetzend wirkenden Komponente nicht direkt reagieren kann, falls eine gute Lagerstabilität des lichtempfindlichen Resistmaterials, als Lösung oder Schichtübertragungsmaterial, im Dunkeln oder im Gelblicht gewünscht wird. Anderenfalls besteht nämlich die Gefahr, daß das lichtempfindliche Resistmaterial bereits vor der bildmäßigen Belichtung mit aktinischem Licht, z. B. während der Lagerung des Aufzeichnungsmaterials, teilweise vernetzt und härtet, wodurch es für den Einsatz in dem erfindungsgemäßen Verfahren nur mit Einschränkungen geeignet sein würde.

Die Menge an o-Nitrocarbinolestergruppierungen der Formel (I), die in dem Polymeren enthalten sind, wird im allgemeinen nicht unter 5 Gewichtsprozent, bezogen auf das Molekulargewicht des Polymeren, liegen und kann in Abhängigkeit von den gewünschten Eigenschaften der lichtempfindlichen Resistschicht und der hieraus hergestellten Reliefbilder oder Resistmuster in weiten Grenzen schwanken. Da bei der Belichtung mit aktinischem Licht die o-Nitrocarbinolestergruppierungen gespalten und freie Carboxylgruppen im Polymeren gebildet werden, wodurch die Löslichkeit des Polymeren geändert wird, ist beispielsweise der Gehalt an o-Nitrocarbinolestergruppierungen der allgemeinen Formel (I) in den Polymeren so zu wählen, daß die Polymeren nach der Belichtung der lichtempfindlichen Resistschicht in wäßrigen Lösungsmitteln, wie z. B. Wasser oder wäßrigalkalischen Lösungen, löslich oder zumindest dispergierbar sind und mit den wäßrigen Entwickler-Lösungsmitteln ausgewaschen werden können.

Die in dem erfindungsgemäßen Verfahren einzusetzende lichtempfindliche Resistschicht enthält auch eine vernetzend wirkende Verbindung mit mindestens zwei reaktiven Gruppen, die unter dem Einfluß von Wärme mit —COOH-Gruppen unter Bildung einer kovalenten chemischen Bindung zu reagieren vermögen. Da in dem erfindungsgemäßen Verfahren die Entwicklung der bildmäßig belichteten Resistschicht nach einer vollflächigen Nachbelichtung erfolgt, ist die Reaktivität dieser vernetzend wirkenden reaktiven Gruppen so auf die Verfahrensbedingungen der vollflächigen Nachbelichtung und bei dem anschließenden Entwickeln der Resistschicht, insbesondere Dauer und Temperatur für die Entwicklung, abzustimmen, daß ein einwandfreies Auswaschen der nicht bildmäßig belichteten, nicht thermisch gehärteten Bereiche der Resistschicht mit dem wäßrigen Entwicklerlösungsmittel gewährleistet bleibt. Ist beispielsweise die Zeit zwischen der vollflächigen Nachbelichtung der Resistschicht und dem Entwickeln bzw. die Entwicklungsdauer oder -temperatur im Vergleich zu der Reaktivität der vernetzend wirkenden Verbindungen mit den reaktiven Gruppen zu hoch, so kann es möglich sein, daß die bei der vollflächigen Nachbelichtung erzeugten Carboxylgruppen vor oder während der Entwicklung in den nicht bildmäßig belichteten Bereichen der Resistschicht mit den vernetzend wirkenden Verbindungen reagieren, so daß dann eine einwandfreie Entwicklung des Reliefbildes oder Resistmusters nicht gewährleistet ist. Es sind daher vorzugsweise solche vernetzend wirkende Verbindungen in der lichtempfindlichen Resistschicht enthalten, die erst in der Wärme bei erhöhter Temperatur, beispielsweise bei Temperaturen oberhalb 40 °C, in merklicher Geschwindigkeit mit den freien Carboxylgruppen reagieren. Reaktive, vernetzend wirkende Gruppen der in Rede stehenden Art, die für das erfindungsgemäße Verfahren besonders geeignet sind, sind beispielsweise Amin-, Imin-, Amid-, Epoxid-, Hydroxy- und/oder gegebenenfalls verkappte Isocyanat-Gruppen.

Gemäß einer Ausführungsform des erfindungsgemäßen Verfahrens können solche lichtempfindlichen Resistschichten verwendet werden, in denen die aromatischen und/oder heteroaromatischen o-Nitrocarbinolestergruppierungen der allgemeinen Formel (I) sowie die vernetzend wirkenden, reaktiven Gruppen der obengenannten Art in ein und demselben Molekül gebunden enthalten sind. Hierbei handelt es sich insbesondere um aromatische und/oder heteroaromatische o-Nitrocarbinolestergruppierungen tragende Copolymerisate, die Comonomere mit den vernetzend wirkenden, reaktiven Gruppen, z. B. Amin-, Imin-, Amid-, Epoxid-, Hydroxy- und/oder gegebenenfalls verkappten Isocyanatgruppen, einpolymerisiert enthalten. Als Comonomere mit den vernetzend wirkenden, gegenüber Carboxylgruppen reaktiven Gruppen, die in den die aromatischen und/oder heteroaromatischen o-Nitrocarbinolestergruppierungen der allgemeinen Formel (I) tragenden Polymeren einpolymerisiert sein können, kommen insbesondere solche mit Epoxid-, Hydroxy-, Isocyanat- und/oder verkappten Isocyanat-Gruppen in Betracht. Beispielhaft seien genannt: N,N-Dimethylaminoethyl-(meth)-acrylat; N-Vinylimidazol; (Meth)acrylamid sowie vorzugsweise Glycidylester ungesättigter Säuren, insbesondere der Acryl- oder

Methacrylsäure, wie Glycidyl-(meth)acrylat ; Glycidylether ungesättigter Alkohole, wie z. B. Allylglycidylether, oder 4-Vinylcyclohexendioxid ; Vinylisocyanat, Allylisocyanat ; Monoester von Diolen mit ungesättigten Säuren, insbesondere von Acryl- oder Methacrylsäure, wie z. B. Hydroxyethyl-(meth)acrylat, Hydroxypropyl-(meth)acrylat oder Butandiol-mono-(meth)acrylat ; und Methylolverbindungen vom Amoltyp, z. B. N-Methylolacrylamid.

Gemäß einer anderen Ausführungsform der Erfindung können die vernetzend wirkenden Verbindungen mit den reaktiven Gruppen zusätzlich zu den Verbindungen mit den aromatischen und/oder heteroaromatischen o-Nitrocarbinolestergruppierungen in der lichtempfindlichen Resistschicht enthalten sein. In diesem Fall kann es sich bei den vernetzend wirkenden Verbindungen sowohl um höhermolekulare Verbindungen, wie z. B. entsprechende Polymere, oder um entsprechende niedermolekulare Verbindungen handeln. Wenn die vernetzend wirkenden Verbindungen mit den reaktiven Gruppen als Zumischkomponente in die lichtempfindliche Resistschicht eingebracht werden, sollen sie mit der die aromatischen und/oder heteroaromatischen o-Nitrocarbinolestergruppierungen enthaltenden Verbindung verträglich sein. Bevorzugte Klassen von vernetzend wirkenden Verbindungen mit zwei oder mehr der reaktiven Gruppen, die als Zumischkomponente in der lichtempfindlichen Schicht enthalten sein können, sind Di- oder Polyepoxide, freie oder verkappte Di- oder Polyisocyanate, Carbodiimide, Di- oder Polyhydroxide sowie Di- oder Polyamine. Die lichtempfindliche Resistschicht kann dabei nur eine oder auch mehrere der vernetzend wirkenden Verbindungen enthalten. Beispielsweise ist es möglich, daß die lichtempfindliche Resistschicht zwei oder mehr verschiedenartige vernetzend wirkende Verbindungen, wie Epoxide, Isocyanate und/oder verkappte Isocyanate, enthält.

Die Di- oder Polyepoxide umfassen die Umsetzungsprodukte von Epichlorhydrin mit Polyolen, die Umsetzungsprodukte von Epichlorhydrin mit Polyaminen, Polyolefinepoxide, epoxidiertes Polybutadien, Epoxiharze vom Novolaktyp, Hochpolymere von Glycidylestern ungesättigter Carbonsäuren, insbesondere der (Meth)acrylsäure, und andere. Von besonderem Interesse sind die Epoxide auf Basis von Epichlorhydrin und Bisphenol A. Durch Substitution des Bisphenol A können die Eigenschaften dieser Epoxide beeinflußt werden ; beispielsweise wird erhöhte Flammwidrigkeit erzielt, wenn Epoxide auf Basis von halogeniertem Bisphenol A, wie z. B. Tetrabrombisphenol A oder Tetrachlorbisphenol A, eingesetzt werden. Eine andere Gruppe von geeigneten Epoxiden sind diejenigen, in denen die endständigen Glycidylgruppen durch aliphatische oder araliphatische Rest verbunden sind. Ein typischer Vertreter dieser Klasse ist der Diglycidylether des 1,4-Butandiols. Derartige Epoxide führen beispielsweise wegen des weniger starren Molekülaufbaues zu flexibleren Härtungsprodukten. Werden Amine anstelle der mehrwertigen Alkohole mit Epichlorhydrin zur Herstellung der Epoxidverbindungen herangezogen, so erhält man Epoxidpropylamine, die im Aufbauprinzip den Glycidylethern ähnlich sind. Ein typischer Vertreter hierfür ist das Bis(epoxipropyl)anilin, welches aufgrund seiner äußerst niedrigen Viskosität als bifunktioneller Verdünner eingesetzt werden kann. Als hochmolekulare vernetzend wirkende Verbindung sind u. a. die Epoxiharze vom Novolaktyp von Interesse. Aufgrund ihrer hohen Funktionalität ergeben sie mit den fotochemisch erzeugten Carbonsäure-Gruppen hochvernetzte Systeme mit hoher Wärmeformbeständigkeit. Das gleiche gilt, wenn Polyglycidyl(meth)acrylate oder andere Polymere, die Glycidylgruppen eingebaut enthalten, verwendet werden.

Durch den Einsatz von cycloaliphatischen Epoxiden, die in ihrem Molekül ein oder mehrere cycloaliphatische Ringe, jedoch keine aromatischen Ringe enthalten, kann z. B. die Lagerstabilität, UV-Beständigkeit sowie die Kriechstromfestigkeit erhöht werden. Bei den cycloaliphatischen Epoxiden kann der Epoxidsauerstoff ausschließlich an die cycloaliphatischen Ringe gebunden sein, wie z. B. im Dicyclopentadiendioxid, er kann ausschließlich in den Seitenketten gebunden sein, wie z. B. beim Diglycidylester der Hexahydrophthalsäure, oder er kann sowohl an den cyclischen Ringen als auch an die Seitenketten gebunden sein, wie z. B. beim Vinylcyclohexandioxid.

Weiterhin kommen als vernetzend wirkende Verbindungen die üblichen Polyisocyanate mit zwei oder mehr Isocyanatgruppen pro Molekül in Betracht, z. B. Alkyl- und Cycloalkyldiisocyanate mit vorzugsweise 4 bis 41 Kohlenstoffatomen im Alkyl- bzw. Cycloalkylrest, wie z. B. Dimersäureisocyanat, Isophorondiisocyanat, Dicyclohexylmethandiisocyanat, 1,4-Butandiisocyanat, Hexamethylendiisocyanat, Heptadecandiisocyanat, 2,2,4-Trimethylhexamethylendiisocyanat; 2,6-Diisocyanatomethylcaproat, Isocyanuratisocyanate, z. B. das Produkt aus der Umsetzung von 2,4-Toluylendiisocyanat mit Hexamethylendiisocyanat, Biurete, wie Hexamethylendiisocyanatbiuret, Aryldi- und -triisocyanate, wie z. B. Toluylendiisocyanat, Diphenylmethandiisocyanat, Naphtylendiisocyanat, Triphenylmethantriisocyanat, Xylylendiisocyanat, gemischt aliphatisch-aromatische Di- und Triisocyanate, funktionelle Gruppierungen enthaltende Di- und Triisocyanate, wie z. B. Carbonylisocyanate wie Carbonyldiisocyanat oder Isophthaloyldiisocyanat, Sulfarylisocyanate, Sulfonyldiisocyanat, oder m-Phenylendisulfonyldiisocyanat, Allophanatisocyanate, Heteroatome enthaltende Di- und Triisocyanate, wie z. B. Umsetzungsprodukte aus Hexamethylcyclotrisilazan und Diphenylmethandiisocyanat, sowie Isocyanatgruppen enthaltende Polymere, z. B. Mischpolymerisate des Vinylisocyanats, Hydroxylgruppen und/oder Aminogruppen enthaltende Polymerisate oder Polykondensate, die mit einem Überschuß an Di- oder Triisocyanaten umgesetzt worden sind.

Da die lichtempfindliche Resistschicht in dem erfindungsgemäßen Verfahren erst durch die Einwirkung von aktinischem Licht in den Zustand der thermischen Härtbarkeit gebracht wird, braucht die Isocyanatkomponente nicht verkappt zu sein, um eine sehr hohe Lagerstabilität des lichtempfindlichen Resistmaterials vor der Verarbeitung in dem erfindungsgemäßen Verfahren zu erreichen. Sofern in dem

erfindungsgemäßen Verfahren jedoch ein großer Verarbeitungsspielraum zwischen dem vollflächigen Nachbelichten der Resistschicht und dem Entwickeln gewünscht wird, z. B. insbesondere dann, wenn diese Prozeßschritte nicht automatisiert hintereinander ablaufen, werden vorteilhaft verkappte Isocyanate als vernetzend wirkende Komponente in der lichtempfindlichen Resistschicht verwendet. Da sich die verkappten Isocyanate erst bei erhöhter Temperatur wieder in die Ausgangskomponenten spalten, ist bei Einsatz von verkappten Isocyanaten als vernetzend wirkenden Verbindungen die Resistschicht nach der Belichtung mit aktinischem Licht bei Raumtemperatur völlig indifferent und besitzt somit einen sehr hohen Verarbeitungspielraum.

Als schützende Komponente für die Verkappung der Isocyanate kommen hauptsächlich Phenole, Acetonoxim, Methylethylketoxim, Acetessigester oder Malonester in Frage ; es eignen sich jedoch ebenfalls Verbindungen wie Acetylaceton, Phthalimid, Caprolactam, Benzolsulfonamid und 2-Mercaptobenzthiazol. Eine gut geeignete, hochwirksame verkappte Isocyanatverbindung erhält man beispielsweise aus 1 Mol Trimethylolpropan, 3 Mol 2,4-Diisocyanatotoluol und 3 Mol Phenol. Als weiteres Beispiel für ein verkapptes Isocyanat sei das Isocyanuratderivat genannt, welches durch Trimerisierung des Umsetzungsproduktes von 2,4-Diisocyanatotoluol und Kresol erhalten wird. Ebenfalls hervorragend als vernetzend wirkende Verbindung geeignet sind die aus Toluylendiisocyanat, Trimethylolpropan, Butandiol und Kresol hergestellten verkappten Isocyanate.

Eine weitere Gruppe von sehr geeigneten vernetzend wirkenden Verbindungen sind wegen ihrer leichten Reaktion mit Carbonsäure-Gruppen die bekannten und üblichen Carbodiimide, wie sie durch Carbodiimidisierung von Diisocyanaten entstehen. Werden als vernetzend wirkende Verbindung alpha, omega-Diisocyanato-polycarbodiimide eingesetzt, erhält man bei der erfindungsgemäßen Härtung der Resistschicht ein dichtes Netzwerk unter Ausbildung von Poly-acylharnstoff. Die Carbodiimide können sowohl aus aromatischen, als auch aus aliphatischen Diisocyanaten aufgebaut sein. Alpha, omega-Diisocyanato-polycarbodiimide aus Isophorondiisocyanat sind in dem erfindungsgemäßen Verfahren als vernetzend wirkende Verbindung u. a. deswegen besonders gut geeignet, da sie als verkapptes Polyisocyanat einen hohen Verarbeitungsspielraum zwischen dem vollflächigen Nachbelichten und dem Entwickeln der Resistschicht gewährleisten.

Vorteilhafte vernetzend wirkende Verbindungen mit mindestens zwei reaktiven Gruppen sind ferner Polymere, die Hydroxy- oder Amino-Gruppen eingebaut enthalten. Erwähnt seien z. B. Phenol-Formaldehyd-Harze, Harnstoff-Formaldehyd-Harze und Melamin-Formaldehyd-Harze. Besonders geeignete Verbindungen aus dieser Klasse sind die Novolake. Die hochmolekularen vernetzend wirkenden Verbindungen mit den reaktiven Gruppen, beispielsweise des letztgenannten Types oder die Glycidylgruppen enthaltenden Polymere, werden in den lichtempfindlichen Resistschichten bevorzugt verwendet, wenn die in der lichtempfindlichen Resistschicht enthaltenen Verbindungen mit den o-Nitrocarbinolestergruppierungen ein relativ niedriges Molekulargewicht besitzen, und können dann, wie bereits erwähnt wurde, als polymeres Bindemittel für die lichtempfindliche Resistschicht dienen. Wenn o-Nitrocarbinolestergruppierungen tragende Polymere mit hohem Molekulargewicht in der lichtempfindlichen Resistschicht enthalten sind, können die zugesetzten vernetzend wirkenden Verbindungen mit den reaktiven Gruppen je nach dem gewünschten Verwendungszweck und angestrebten Eigenschaftsbild niedermolekular oder auch hochmolekular sein.

Das Verhältnis der reaktiven Gruppen in den vernetzend wirkenden Verbindungen zu den o-Nitrocarbinolestergruppierungen der allgemeinen Formel (I) in den diese Gruppierungen enthaltenden Verbindungen richtet sich in Abhängigkeit von der Art der eingesetzten Komponenten insbesondere nach dem angestrebten Eigenschaftsbild der lichtempfindlichen Resistschicht bzw. der hieraus hergestellten Reliefbilder oder Resistmuster. Es kann daher in weiten Grenzen variiert werden, ist jedoch auf alle Fälle so zu wählen, daß der gewünschte Vernetzungs- und Härtungsgrad in den Reliefbildern und Resistmustern erzielt wird. Wird auf eine starke Vernetzung bei der Härtung Wert gelegt, so werden im allgemeinen sehr reaktive vernetzend wirkende Verbindungen vorzugsweise im Überschuß in Bezug auf die o-Nitrocarbinolestergruppierungen eingesetzt. Ist eine weniger starke Vernetzung hinreichend, so können die vernetzend wirkenden Verbindungen sowohl bezüglich Menge als auch Reaktivität entsprechend reduziert werden.

Die in dem erfindungsgemäßen Verfahren eingesetzten lichtempfindlichen Resistschichten können neben den Verbindungen mit den o-Nitrocarbinolestergruppierungen und den Verbindungen mit den vernetzend wirkenden, reaktiven Gruppen sowie gegebenenfalls den polymeren Bindemitteln darüber hinaus weitere übliche und an sich bekannte Zusatz- und Hilfsstoffe enthalten. Bei diesen Zusatz- und Hilfsstoffen kann es sich einerseits um Verbindungen handeln, die zur Vereinfachung der Herstellung der lichtempfindlichen Resistschicht bzw. des Aufzeichnungsmaterials zugesetzt worden sind. Hierzu gehören beispielsweise Weichmacher oder Verlaufsmittel. Weichmacher werden in die lichtempfindliche Resistschicht insbesondere dann eingearbeitet, wenn diese in trockenem Zustand, insbesondere durch Laminieren auf den permanenten Träger aufgebracht werden soll. Beispiele für weichmachende Verbindungen, die mit den o-Nitrocarbinolestergruppierungen enthaltenden Verbindungen, insbesondere den Polymeren, verträglich sein sollen, sind Trikresylphosphat, n-Butyl-benzyl-phthalat und flüssige Polyester aus aliphatischen Dicarbonsäuren und bifunktionellen Glykolen, insbesondere Polyester aus Adipinsäure und 1,2-Propylenglykol oder 1,4-Butandiol mit einer Viskosität von 1 000 bis 15 000 cP. Werden als vernetzend wirkende Verbindungen mit mindestens zwei reaktiven Gruppen niedermolekulare

Substanzen als Zumischkomponente eingesetzt, so können diese auch als Weichmacher wirken und den Zusatz von gesonderten weichmachenden Verbindungen teilweise oder vollständig überflüssig machen. Verlaufsmittel, wie z. B. Silikonöle, sind insbesondere dann empfehlenswert, wenn die lichtempfindliche Resistschicht durch Gießen aus Lösung auf einen Träger aufgebracht werden soll.

Andererseits können die lichtempfindlichen Resistschichten solche Zusatzstoffe enthalten, die die anwendungstechnischen Eigenschaften der lichtempfindlichen Resistschicht verbessern oder modifizieren. Hierzu gehören beispielsweise Katalysatoren, die die thermische Härtung und Vernetzung der bildmäßig belichteten Resistschicht, d. h. also die Umsetzung zwischen den freien Carboxylgruppen und den reaktiven Gruppen der vernetzend wirkenden Verbindungen, beschleunigen ; Sensibilisatoren, die die Lichtempfindlichkeit und die spektrale Empfindlichkeit der lichtempfindlichen Resistschicht verbessern ; Farbstoffe, Pigmente und/oder fotochrome Substanzen.

Als Katalysatoren für die thermische Härtung der belichteten Resistschicht können je nach der Art der verwendeten vernetzend wirkenden Verbindung die für solche Reaktionen an sich bekannten Säuren und Basen eingesetzt werden. Es ist allerdings zu beachten, daß sich damit im allgemeinen der Verarbeitungsspielraum zwischen der vollflächigen Nachbelichtung und der Entwicklung der Resistschicht einengt, so daß die Menge an Katalysatoren im allgemeinen gering gehalten wird. Teilweise ist bereits der Zusatz von Katalysatormengen im ppm-Bereich hinreichend. Als Beispiele für basische Katalysatoren seien genannt : Benzyldimethylamin, Benzyltrimethylammoniumhydroxid, Diazabicyclooctan, N,N,N',N'-Tetramethyl-1,3-diaminobutan, 2-Dimethylamino-2-hydroxypropan, 2-Diethylaminomethylphenol, 2,4,6-Tri-(dimethylaminoethyl)-phenol, zinnorganische Verbindungen wie Zinnoctoat und andere.

Beispiele für Sensibilisatoren sind : Xanthen-Farbstoffe, wie Fluorescein, Eosin und Rhodamin S, sowie Triplet-Energieüberträger, wie sie beispielsweise N. J. Turro in seinem Buch « Molecular Photochemistry », W. A. Benjamin Inc., New York 1967, auf Seite 132 beschreibt. Als Farbstoffe, die in der lichtempfindlichen Resistschicht enthalten sein können, haben sich u. a. Sudanfarbstoffe, Polymethinfarbstoffe, Azofarbstoffe, Phthalocyanin-Farbstoffe oder Dispersionsfarbstoffe sowie Eosin, Kristallviolett oder Malachitgrün bewährt. Besonders vorteilhaft sind solche Farbstoffe, die bei der Belichtung mit aktinischem Licht ihre Färbung reversibel oder irreversibel ändern. So werden z. B. Sudanfarbstoffe, Polymethinfarbstoffe oder Azofarbstoffe durch zugesetzte Fotoinitiatoren, wie Benzoinether, Benzilketale, Benzophenon oder Michler's Keton, in der lichtempfindlichen Schicht entsprechend der bildmäßigen Belichtung ausgebleicht. Besonders erwähnt seien die Polymethinfarbstoffe der allgemeinen Formel (II)

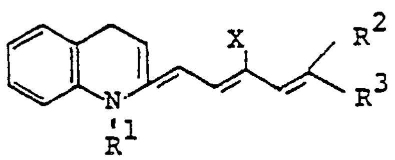

(II)

worin bedeuten $R^1$ Alkyl ; $R^2$ —CN ; $R^3$ —CN, —$COOR^4$, —Ph—$R^5$ ; $R^4$ Alkyl ; $R^5$ —$NO_2$, Halogen, Alkyl, Alkoxy ; und X Halogen. Bevorzugt sind auch Farbstoffvorstufen, z. B. Kristallviolett-Leukobase oder Malachitgrün-Leukobase, zusammen mit halogenierten Kohlenwasserstoffen, insbesondere halogenierten aromatischen Kohlenwasserstoffen, die mindestens zwei an einen Benzolkern gebundene Dichlormethyl-Gruppen aufweisen.

Bei dem erfindungsgemäßen Verfahren wird die lichtempfindliche Resistschicht zunächst auf den permanenten Träger aufgebracht, auf dem die Reliefbilder oder Resistmuster gebildet werden sollen. Dies kann, wie bereits weiter oben erwähnt wurde, beispielsweise durch Gießen der lichtempfindlichen Resistschicht aus Lösung geschehen. Man kann aber auch die lichtempfindliche Resistschicht zunächst auf einen temporären Träger aufbringen und die im allgemeinen trockene und feste Resistschicht dann nach dem Schichtübertragungsverfahren auf den permanenten Träger unter Anwendung von Druck und/oder Wärme auflaminieren. Die Schichtdicke der lichtempfindlichen Resistschicht hängt von der jeweiligen Anwendung ab und liegt im allgemeinen im Bereiche von 0,1 bis 2 000 µm.

In einer besonderen Ausführungsform des erfindungsgemäßen Verfahrens wird die lichtempfindliche Resistschicht zunächst auf einem temporären Träger, z. B. einer Polyesterfolie, erzeugt und vor dem Auflaminieren auf den permanenten Träger, der den späteren Untergrund für die Reliefbilder und Resistmuster darstellt, kurzzeitig vollflächig mit aktinischem Licht vorbelichtet. Diese Vorbelichtung geschieht bevorzugt auf der Seite der lichtempfindlichen Resistschicht, die später auf den permanenten Träger aufgebracht wird und kann bis zu 70 % der Zeit für die nachfolgende bildmäßige Hauptbelichtung betragen. Diese Vorbelichtung führt u. a. zu einer verbesserten Haftung der Resistschicht auf dem permanenten Träger, insbesondere metallischen oder metalloxidischen Untergründen, ohne daß hierdurch etwa die originalgetreue und exakte Wiedergabe des Übertragenen Bildes bei der Herstellung der Reliefbilder oder Resistmuster nachteilig beeinflußt wird. Dadurch, daß diese Vorbelichtung durch eine Lichtstrecke entweder während der Herstellung des Schichtübertragungsmaterials oder während des Laminierens unmittelbar vor dem Aufbringen der lichtempfindlichen Resistschicht auf den permanenten Träger vorgenommen werden kann, läßt sich diese Verfahrensvariante ohne besondere zusätzliche

Aufwendungen oder Verarbeitungsschritte durchführen.

Die auf den permanenten Träger, der den Untergrund für die Reliefbilder oder Resistmuster darstellt, aufgebrachte lichtempfindliche Resistschicht wird erfindungsgemäß zunächst durch eine geeignete Bildvorlage mit aktinischem Licht in an sich bekannter Weise bildmäßig belichtet. Geeignete Lichtquellen hierfür sind solche, die aktinisches Licht im Wellenlängenbereich von 200 bis 600 nm, vorzugsweise im Bereich von 300 bis 420 nm, austrahlen, also z. B. Kohlenbogenlampen, Quecksilberhochdrucklampen, Xenonhochdrucklampen und insbesondere Quecksilberniederdruckfluoreszenzlampen. Die Belichtungszeiten für die bildmäßige Belichtung, die insbesondere von der Art und der Dicke der lichtempfindlichen Resistschicht abhängen, liegen im allgemeinen im Bereich von etwa 0,05 bis 50 Minuten und richten sich auch nach der Stärke der verwendeten Lichtquelle.

Nach der bildmäßigen Belichtung der lichtempfindlichen Resistschicht, bei der in den belichteten Bereichen die o-Nitrocarbinolestergruppierungen unter Bildung von freien Carboxylgruppen gespalten werden, werden die belichteten Schichtanteile thermisch vernetzt und gehärtet. Diese thermische Vernetzung kann beispielsweise bei Raumtemperatur erfolgen, jedoch sind dann im allgemeinen sehr lange Härtungszeiten notwendig. Vorteilhafterweise wird daher die Härtung und Vernetzung bei erhöhten Temperaturen durchgeführt, indem man die bildmäßig belichtete Resistschicht auf Temperaturen im Bereich von vorzugsweise 50 bis 250 °C, insbesondere 60 bis 200 °C, erwärmt. Die Dauer für die Härtung und Vernetzung, die im Bereich von etwa 10 Minuten bis einigen Stunden, z. B. 5 Stunden, liegen kann, ist u. a. abhängig von der Art und Reaktivität der eingesetzten vernetzend wirkenden Verbindung, der Anzahl der bei der bildmäßigen Belichtung erzeugten freien Carboxylgruppen, dem gewünschten Vernetzungs- und Härtungsgrad, der Schichtdicke etc. Beispielsweise erfordert die Vernetzung der freien Carboxylgruppen mit Epoxidverbindungen relativ hohe Härtungstemperaturen. So muß man beispielsweise ein äquimolares unkatalysiertes Gemisch aus Carbonsäure und einem Diepoxid aus 2,2-Bis-(p-hydroxyphenyl)-propan 2 bis 4 Stunden auf etwa 150° bis 200 °C erhitzen, um alle Epoxidgruppen umzusetzen. Man kann die Härtung, beispielsweise unter Einsatz eines Überschusses oder auch Unterschusses an Epoxidverbindungen bzw. allgemein den vernetzend wirkenden Verbindungen, auch stufenweise vornehmen, indem man beispielsweise zunächst auf Temperaturen bis etwa 150 °C erwärmt und anschließend bei Temperaturen über 150 °C, insbesondere bei einer Temperatur um 200 °C oder darüber endgültig aushärtet.

Die bildmäßig belichtete Resistschicht wird nach der thermischen Härtung und Vernetzung erfindungsgemäß vollflächig mit aktinischem Licht nachbelichtet. Hierdurch werden in den nicht gehärteten, nicht vernetzten Bereichen der Resistschicht freie Carboxylgruppen erzeugt, die das anschließende Auswaschen dieser Schichtanteile mit einem wäßrigen Entwicklerlösungsmittel ermöglichen. Für diese vollflächige Nachbelichtung können die gleichen Lichtquellen herangezogen werden wie für die vorerwähnte bildmäßige Belichtung. Ganz allgemein wird die vollflächige Nachbelichtung mit einer solchen Intensität und für eine solche Dauer durchgeführt, daß sich hierdurch in der Resistschicht eine hinreichende Anzahl von freien Carboxylgruppen für das Auswaschen der nicht gehärteten, nicht vernetzten Schichtanteile mit dem wäßrigen Entwicklerlösungsmittel bildet. Die Dauer der vollflächigen Nachbelichtung liegt üblicherweise im Bereich von 0,05 bis 50 Minuten. Es hat sich dabei überraschenderweise gezeigt, daß erfindungsgemäß die Resistschicht auch dann mit einem wäßrigen Entwicklerlösungsmittel auswaschbar ist, wenn die eingesetzte lichtempfindliche Resistschicht eine niedermolekulare, o-Nitrocarbinolestergruppierungen der Formel (I) aufweisende Verbindung und ein polymeres Bindemittel enthält und dieses polymere Bindemittel selber nicht wasserlöslich ist.

Bei dem erfindungsgemäß einzusetzenden wäßrigen Entwicklerlösungsmittel kann es sich um Wasser als solches oder auch um Mischungen von Wasser mit wasserlöslichen, organischen Lösungsmitteln handeln, beispielsweise um Gemische von Wasser mit aliphatischen Alkoholen, insbesondere Methanol oder Ethanol ; Ketonen, wie z. B. Aceton ; oder cyclischen Ethern, z. B. Tetrahydrofuran. Insbesondere wird als Entwicklerlösungsmittel Wasser eingesetzt. Der pH-Wert des Entwicklerlösungsmittels ist zweckmäßig größer als 7,5, wodurch wenigstens ein Teil der freien Carboxylgruppen in die Salzform übergeführt wird. Die optimale Alkalimenge bzw. der optimale pH-Wert ist dabei natürlich abhängig von dem verwendeten Schichtmaterial und der Belichtungsdauer und -intensität bei der vollflächigen Nachbelichtung, d. h. also der Menge der hierbei gebildeten freien Carboxylgruppen. Als Alkalien für das Entwicklerlösungsmittel können z. B. Zusätze von Borax, Dinatriumhydrogenphosphat, Soda, Alkalihydroxiden oder von organischen Basen, wie Di- oder Triethanolamin, verwendet werden. Der Auswaschlösung können auch Zusätze wie beispielsweise oberflächenaktive Substanzen, Natriumcarboxymethylcellulose, Polyvinylalkohol, Polynatriumacrylat und dergleichen zugegeben werden.

Im übrigen sind die Bedingungen (z. B. Dauer und Temperatur) für die Entwicklung der belichteten Resistschicht auf den vorhandenen Verarbeitungsspielraum abzustellen. Da die lichtempfindliche Resistschicht vernetzend wirkende Verbindungen enthält, die mit den bei der vollflächigen Nachbelichtung gebildeten freien Carboxylgruppen zu reagieren vermögen, andererseits jedoch die Entfernung der nicht bildmäßig belichteten und gehärteten Schichtanteile bei der Entwicklung vollständig bis auf den Träger und unter Ausbildung von scharfen Konturen erfolgen soll, wird die Entwicklung der Resistschicht in aller Regel unmittelbar im Anschluß an die vollflächige Nachbelichtung vorgenommen. Das Auswaschen der nicht bildmäßig belichteten und gehärteten Schichtanteile kann dabei in üblicher Weise, beispielsweise durch Besprühen, Ausreiben oder Ausbürsten mit dem wäßrigen Entwicklerlösungsmittel

geschehen. Zur Beschleunigung des Entwicklungsvorganges können, in Abhängigkeit von der in der Resistschicht enthaltenen vernetzend wirkenden Verbindung, erhöhte Temperaturen, beispielsweise bis etwa 40 °C, angewandt werden. Die Entwicklungsdauer liegt im allgemeinen im Bereich von einigen Minuten.

Die nach dem Auswaschen der Resistschicht erhaltenen Reliefbilder oder Resistmuster können in üblicher Weise getrocknet werden. Ein besonderer Vorteil des erfindungsgemäßen Verfahrens liegt darin, daß die erhaltenen Reliefbilder und Resistmuster thermisch nachgehärtet und nachvernetzt werden können, wodurch die Eigenschaften der Reliefbilder oder Resistmuster variiert und abgestimmt und dem jeweiligen Anwendungszweck entsprechend angepaßt werden können. Die für die thermische Nachhärtung und Nachvernetzung notwendigen freien Carboxylgruppen werden in aller Regel bereits bei der vollflächigen Nachbelichtung der Resistschicht in hinreichender Anzahl erzeugt. Gegebenenfalls sind die Bedingungen für die vollflächige Nachbelichtung auf die Erfordernisse der thermischen Nachhärtung und Nachvernetzung in sinnvoller Weise abzustimmen. Die thermische Nachhärtung und Nachvernetzung kann in gleicher Weise wie die zuvor beschriebene selektive Härtung und Vernetzung der bildmäßig belichteten Bereiche durchgeführt werden. Im allgemeinen werden hierzu die Reliefbilder oder Resistmuster auf Temperaturen im Bereich von vorzugsweise 50° bis 250 °C, insbesondere 60 bis 200 °C, für eine Dauer von einigen Minuten bis einigen Stunden, gegebenenfalls in mehreren Stufen mit steigender Temperatur, erwärmt. Durch diese Nachhärtung und Nachvernetzung können dabei insbesondere die mechanische Festigkeit, Temperaturbeständigkeit sowie Lösungsmittelbeständigkeit der Reliefbilder und Resistmuster erhöht werden. Vorzugsweise wird im Fall der thermischen Nachhärtung und Nachvernetzung die selektive thermische Härtung und Vernetzung der bildmäßig belichteten Bereiche der lichtempfindlichen Resistschicht relativ kurz gehalten, da durch diese selektive thermische Härtung und Vernetzung der bildmäßigen Bereiche in diesem Fall nur eine Löslichkeitsdifferenzierung bewirkt zu werden braucht, während das Einstellen der gewünschten Produkteigenschaften der Reliefbilder oder Resistmuster über die thermische Nachhärtung und Nachvernetzung erfolgen kann.

Durch das erfindungsgemäße Verfahren erhält man bei hohem Auflösungsvermögen Reliefbilder oder Resistmuster mit einer insbesondere bei kurzzeitigen thermischen Belastungen großen Temperaturbeständigkeit, je nach Komponenten beispielsweise bis oberhalb 270 °C, ausgezeichneten mechanischen Eigenschaften, hoher Durchschlags- und Kriechstromfestigkeit sowie stark verbesserter Resistenz gegen aggressive Prozeßchemikalien, insbesondere starke Säuren- und Laugen, wie sie bei der Weiterverarbeitung der Reliefbilder oder Resistmuster zur Anwendung kommen können.

Das erfindungsgemäße Verfahren bzw. die hiernach hergestellten Reliefbilder und Resistmuster finden mit besonderem Vorteil Anwendung zur Herstellung von Dickschichtschaltungen, Dünnschichtschaltungen, z. B. für die Hochfrequenztechnik, von integrierten Schaltungen, allgemein von Halbleitern und zur Herstellung gedruckter Schaltungen und Lötstoppmasken, sowie zur Herstellung von Offset-Druckplatten. Die Techniken in den genannten Anwendungsgebieten beim Einsatz von lichtempfindlichen Aufzeichnungsmaterialien sind dabei als solche hinreichend bekannt, so daß an dieser Stelle hierauf nicht näher eingegangen zu werden braucht. Gewünschtenfalls kann das erfindungsgemäß hergestellte Resistmuster, z. B. nach der Modifizierung der freigelegten Bereiche des Trägers, vom Träger entfernt werden, etwa durch Strippen mit einem geeigneten Lösungsmittel, wie Methylenchlorid.

Die Erfindung wird durch die nachfolgenden Beispiele näher erläutert. Die in den Beispielen angegebenen Teile und Prozente beziehen sich, soweit nicht anders vermerkt, auf das Gewicht.

## Beispiel 1

72 Teile eines Methylmethacrylat-Copolymerisates, welches 25 % o-Nitrobenzylacrylat einpolymerisiert enthielt, 27 Teile eines Bisphenol-A-diglycidylethers (Epikote® 828 der Firma Shell), 0,7 Teile Benzildimethylketal, 0,1 Teile eines schwarzen Farbstoffes und 0,2 Teile des Polymethinfarbstoffes der allgemeinen Formel (II), worin $R^1$ eine Methylgruppe, $R^2$ eine Nitrilgruppe, $R^3$ eine —COOEt-Gruppe und X Chlor darstellt, wurden in 160 Volumen-Teilen Essigsäureethylester gelöst. Aus dieser Lösung wurden auf zwei Polyethylenterephthalatfolien (temporäre Träger) zwei lichtempfindliche Resistschichten so gegossen, daß nach Entfernung des Lösungsmittels und Trocknung eine Schichtdicke von jeweils 50 µm resultierte. Die so hergestellten lichtempfindlichen Resistschichten wurden bei 100 °C mit ihrer freien Oberfläche beidseitig auf eine gedruckte Schaltung auflaminiert. Nach Abziehen der Polyesterfolien wurden die beiden lichtempfindlichen Resistschichten durch je eine Negativ-Vorlage in einem Flachbelichter jeweils 4 Minuten belichtet. Danach wurde das lichtempfindliche Aufzeichnungsmaterial je 1 Stunde bei 60 °C, 80 °C, 100 °C, 120 °C und 150 °C und anschließend noch 0,5 Stunden bei 200 °C erhitzt, wodurch in den bildmäßig belichteten Bereichen die Resistschichten selektiv thermisch gehärtet und vernetzt wurden. Anschließend wurden beide Resistschichten jeweils 4 Minuten vollflächig nachbelichtet und dann mit einem Entwicklerlösungsmittel aus 81 % Wasser, 16 % 2-Butoxyethanol und 3 % Triethanolamin in 10 Minuten ausgewaschen. Es wurden scharfkantige, den Vorlagen exakt entsprechende Resistbilder erhalten, die durch Abblasen mit Druckluft von Entwicklerlösungsmittel-Resten befreit wurden. Die erhaltenen Resistbilder besaßen die für Lötstoppmasken gewünschten elektrischen Eigenschaften, thermische Stabilität und sehr gute mechanische Festigkeit. Die mit den Lötstoppmasken versehene Leiterplatte konnte in üblicher Weise bestückt und gelötet werden.

Beispiel 2

Eine Lösung aus 110 Teilen eines Acrylat-Copolymerisates (87 % Acrylsäure-1-(o-nitrophenyl)-ethylester und 13 % Acrylamid), 12 Teilen eines Bisphenol-A-diglycidylethers (Epikote® 828 der Firma Shell) und 1,2 Teilen eines blauen Farbstoffes in 800 Teilen Essigester wurden nach Filtration so auf eine elektrisch aufgerauhte, anodisch oxidierte Aluminiumplatte für den Offset-Druck (mittlere Rautiefe : 3,5 µm) aufgetragen, daß eine lichtempfindliche Resistschicht mit einem Trockengewicht von 1,5 g/m² resultierte. Nach dem Ablüften bei 60 °C wurde die lichtempfindliche Resistschicht durch eine fotographische Negativ-Vorlage mit einer dotierten Quecksilber-Hochdrucklampe (Abstand 80 cm) 1 Minute bildmäßig belichtet. Darauf wurden durch Erwärmen der Resistschicht mit steigenden Temperaturen im Bereich von 60 bis 150 °C die belichteten Bereiche der Resistschicht selektiv gehärtet und vernetzt. Nach einer vollflächigen Nachbelichtung (ca. 10 Minuten) wurde die Resistschicht in einem Sprühwascher mit einem Gemisch aus 82 Teilen Wasser, 15 Teilen 2-Butoxyethanol und 3 Teilen Triethanolamin ausgewaschen. Nach dem Trocknen der Resistschicht resultierte eine sehr auflagenstarke Offset-Druckplatte.

**Patentansprüche**

1. Verfahren zur Herstellung von Reliefbildern oder Resistmustern, die ein Negativabbild einer bildmäßigen Vorlage darstellen, bei dem eine auf einem Träger aufgebrachte lichtempfindliche und nach der Belichtung vernetzbare Resistschicht, die als lichtempfindliche Komponente eine Verbindung mit mindestens zwei o-Nitrocarbinolestergruppierungen der allgemeinen Formel (I)

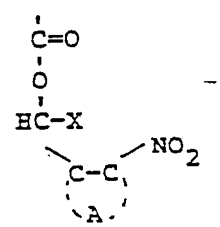

(I)

wobei A den Rest eines aromatischen oder heteroaromatischen, gegebenenfalls substituierten Ringsystems mit 5 bis 14 Ringgliedern und X ein Wasserstoffatom, einen Alkylrest mit 1 bis 8 Kohlenstoffatomen oder einen gegebenenfalls substituierten Aryl- oder Aralkylrest bedeuten, und als vernetzend wirkende Verbindung eine Verbindung mit mindestens zwei reaktiven Gruppen enthält, die unter dem Einfluß von Wärme mit —COOH-Gruppen unter Bildung einer kovalenten chemischen Bindung zu reagieren vermögen, mit aktinischem Licht bildmäßig belichtet wird, darauf die belichteten Bereiche der Resistschicht selektiv thermisch gehärtet und vernetzt und anschließend die unvernetzten Bereiche der Resistschicht mit einem Entwicklerlösungsmittel ausgewaschen werden, dadurch gekennzeichnet, daß nach dem bildmäßigen Belichten und selektiven thermischen Härten und Vernetzen der belichteten Bereiche noch einmal vollflächig mit aktinischem Licht nachbelichtet und anschließend mit einem wäßrigen Entwicklerlösungsmittel ausgewaschen wird.

2. Verfahren nach Anspruch 1, dadurch gekennzeichnet, daß die lichtempfindliche Resistschicht eine o-Nitrocarbinolestergruppierungen der allgemeinen Formel (I) aufweisende Verbindung enthält, in der das den o-Nitrocarbinolestergruppierungen der Formel (I) zugrundeliegende Carbinol o-Nitrobenzylalkohol, 2-Nitro-6-chlorbenzylalkohol, 2-Nitro-2-4-cyanbenzylalkohol, 2-Nitro-4,5-dimethoxybenzylalkohol, alpha-Methyl-o-nitrobenzylalkohol, alpha-Phenyl-o-nitrobenzylalkohol oder alpha-(o-Nitrophenyl)-o-nitrobenzylalkohol ist.

3. Verfahren nach Ansprüchen 1 und 2, dadurch gekennzeichnet, daß die lichtempfindliche Resistschicht als Verbindung mit den o-Nitrocarbinolestergruppierungen der Formel (I) einen Di- und/oder Polyester einer niedermolekularen Di- und/oder Polycarbonsäure sowie ein mit diesem Ester verträgliches polymeres Bindemittel enthält.

4. Verfahren nach Ansprüchen 1 und 2, dadurch gekennzeichnet, daß die lichtempfindliche Resistschicht ein Polymeres mit einem Molekulargewicht > 500 enthält, welches zumindest 5 Gewichtsprozent, bezogen auf das Molekulargewicht des Polymeren, aromatische und/oder heteroaromatische o-Nitrocarbinolestergruppierungen der Formel (I) im Molekül gebunden enthält.

5. Verfahren nach Anspruch 4, dadurch gekennzeichnet, daß die lichtempfindliche Resistschicht ein o-Nitrocarbinolestergruppierungen der Formel (I) tragendes Polymeres enthält, welches sich von einem Homo- oder Copolymerisat der Acrylsäure, Methacrylsäure, Maleinsäure, Fumarsäure und/oder Crotonsäure ableitet.

6. Verfahren nach einem der Ansprüche 1 bis 5, dadurch gekennzeichnet, daß die lichtempfindliche Resistschicht eine Verbindung, insbesondere ein Polymeres, enthält, welche neben den o-Nitrocarbinolestergruppierungen der Formel (I) gleichzeitig die vernetzend wirkenden, gegenüber —COOH-Gruppen

reaktiven Gruppen im Molekül eingebaut enthält.

7. Verfahren nach Anspruch 6, dadurch gekennzeichnet, daß die die o-Nitrocarbinolestergruppierungen der Formel (I) enthaltende Verbindung zusätzlich Amin-, Imin-, Amid-, Epoxid-, Hydroxy-, Isocyanat- und/oder verkappte Isocyanat-Gruppen eingebaut enthält.

8. Verfahren nach einem der Ansprüche 1 bis 5, dadurch gekennzeichnet, daß die lichtempfindliche Resistschicht neben der Verbindung mit den o-Nitrocarbinolestergruppierungen der Formel (I) zusätzlich eine oder mehrere vernetzend wirkende Verbindungen mit mindestens zwei reaktiven Gruppen der genannten Art enthält.

9. Verfahren nach Anspruch 8, dadurch gekennzeichnet, daß die lichtempfindliche Resistschicht als vernetzend wirkende Verbindung Epoxide, Isocyanate, verkappte Isocyanate, alpha,omega-Diisocyanatopolycarbodiimide, Alkohole und/oder Amine enthält.

10. Verfahren nach einem der Ansprüche 1 bis 9, dadurch gekennzeichnet, daß die lichtempfindliche Resistschicht als weitere Zusatzstoffe Weichmacher, Verlaufsmittel, Katalysatoren für die thermische Härtung, Sensibilisatoren, Farbstoffe, Pigmente und/oder fotochrome Substanzen enthält.

11. Verfahren nach einem der Ansprüche 1 bis 10, dadurch gekennzeichnet, daß die thermische Härtung und Vernetzung der bildmäßig belichteten Resistschicht bei Temperaturen im Bereich von 50 bis 250 °C vorgenommen wird.

12. Verfahren nach einem der Ansprüche 1 bis 11, dadurch gekennzeichnet, daß nach dem Auswaschen mit dem wäßrigen Entwicklerlösungsmittel noch eine thermische Nachvernetzung und Nachhärtung durchgeführt wird.

13. Verfahren nach einem der Ansprüche 1 bis 12, dadurch gekennzeichnet, daß die feste lichtempfindliche Resistschicht unter Anwendung von Druck und/oder Wärme auf den Träger auflaminiert worden ist.

14. Verfahren nach Anspruch 13, dadurch gekennzeichnet, daß die lichtempfindliche Resistschicht vor dem Auflaminieren auf den Träger auf der dem Träger zugewandten Seite kurzzeitig mit aktinischem Licht vollflächig vorbelichtet worden ist.

15. Anwendung des Verfahrens nach einem der Ansprüche 1 bis 14 in der Halbleitertechnik, zur Herstellung von Leiterbahnen, integrierten oder gedruckten Schaltungen oder von Lötstoppmasken.

16. Anwendung des Verfahrens nach einem der Ansprüche 1 bis 14 zur Herstellung von Offset-Druckplatten.

**Claims**

1. A process for the production of a relief image or resist image which constitutes a negative image of an image-bearing transparency, in which a photosensitive resist layer which is applied to a base, is crosslinkable after exposure and contains, as the photosensitive component, a compound possessing two ore more o-nitrocarbinol ester groups of the general formula (I)

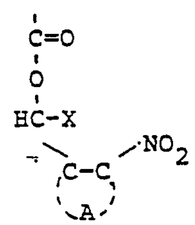

(I)

where A is a radical of an unsubstituted or substituted 5-membered to 14-membered aromatic or heteroaromatic ring system, and X is hydrogen, alkyl of 1 to 8 carbon atoms or an unsubstituted or substituted aryl or aralkyl radical, and which also contains, as compound which effects crosslinking, a compound possessing two or more reactive groups which are capable of reacting with —COOH groups under the action of heat to form a covalent chemical bond, is exposed imagewise to actinic light, the exposed areas of the resist layer are subjected to selective thermal hardening and crosslinking, and then the non-crosslinked areas of the resist layer are washed out with a developer, characterized in that, after imagewise exposure and selective thermal hardening and crosslinking of the exposed areas, the resist layer is post-exposed uniformly to actinic light and then washed out with an aqueous developer.

2. A process as claimed in claim 1, characterized in that the photosensitive resist layer contains a compound possessing o-nitrocarbinol ester groups of the general formula (I), in which the carbinol on which the o-nitrocarbinol ester groups of the formula (I) are based is o-nitrobenzyl alcohol, 2-nitro-6-chlorobenzyl alcohol, 2-nitro-4-cyanobenzyl alcohol, 2-nitro-4,5-dimethoxybenzyl alcohol, α-methyl-o-nitrobenzyl alcohol, α-phenyl-o-nitrobenzyl alcohol or α-(o-nitrophenyl)-o-nitrobenzyl alcohol.

3. A process as claimed in claims 1 and 2, characterized in that the photosensitive resist layer contains, as the compound possessing the o-nitrocarbinol ester groups of the formula (I), a di- and/or polyester of a low molecular weight di- and/or polycarboxylic acid and a polymeric binder which is

compatible with this ester.

4. A process as claimed in claims 1 and 2, characterized in that the photosensitive resist layer contains a polymer which has a molecular weight of above 500 and contains not less than 5 % by weight, based on the molecular weight of the polymer, of aromatic and/or heteroaromatic o-nitrocarbinol ester groups of the formula (I) bonded in the molecule.

5. A process as claimed in claim 4, characterized in that the photosensitive resist layer contains a polymer which possesses o-nitrocarbinol ester groups of the formula (I) and is derived from a homopolymer or copolymer of acrylic acid, methacrylic acid, maleic acid, fumaric acid and/or crotonic acid.

6. A process as claimed in any of claims 1 to 5, characterized in that the photosensitive resist layer contains a compound, in particular a polymer, which, in addition to the o-nitrocarbinol ester groups of the formula (I), also contains, incorporated in the molecule, the crosslinking groups which are capable of reacting with —COOH groups.

7. A process as claimed in claim 6, characterized in that the compound possessing o-nitrocarbonil ester groups of the formula (I) additionally contains amine, imine, amide, expoxide, hydroxyl, isocyanate and/or blocked isocyanate groups.

8. A process as claimed in any of claims 1 to 5, characterized in that the photosensitive resist layer contains, in addition to the compound possessing the o-nitrocarbinol ester groups of the formula (I), one or more crosslinking compounds possessing two or more reactive groups of the said type.

9. A process as claimed in claim 8, characterized in that the photosensitive resist layer contains, as crosslinking compounds, epoxides, isocyanates, blocked isocyanates, α,ω-diisocyanatopolycarbodiimides, alcohols and/or amines.

10. A process as claimed in any of claims 1 to 9, characterized in that the photosensitive resist layer contains, as further additives, plasticizers, flow improvers, catalysts for the thermal hardening, sensitizers, dyes, pigments and/or photochromic substances.

11. A process as claimed in any of claims 1 to 10, characterized in that the thermal hardening and crosslinking of the imagewise exposed resist layer is carried out at from 50 to 250 °C.

12. A process as claimed in any of claims 1 to 11, characterized in that, after washout with the aqueous developer, thermal post-curing and subsequent crosslinking is also carried out.

13. A process as claimed in any of claims 1 to 12, characterized in that the solid photosensitive resist-layer is laminated onto the base using pressure and/or heat.

14. A process as claimed in claim 13, characterized in that the photosensitive resist layer, before being laminated onto the base, is pre-exposed uniformly for a short time to actinic light, on that side which faces the base.

15. The use of a process as claimed in any of claims 1 to 14 in semiconductor technology for the production of conductors, integrated or printed circuits, or solder masks.

16. The use of a process as claimed in any of claims 1 to 14 for the production of offset printing plates.

**Revendications**

1. Procédé de préparation d'images en relief ou de dessins-réserves (resist), qui représentent une image négative d'un modèle selon l'image, procédé selon lequel on expose, conformément à l'image, à une lumière actinique une couche-réserve (resist) sensible à la lumière, appliquée sur un support et réticulable après exposition, couche qui contient, comme composants sensibles à la lumière, un composé ayant au moins deux groupements ester de O-nitrocarbinol de formule générale (I)

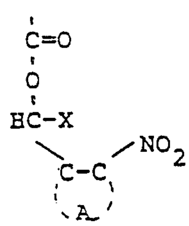

(I)

où A représente le reste d'un système cyclique aromatique ou hétéro-aromatique, éventuellement substitué, ayant 5 à 14 termes cycliques, et X un atome d'hydrogène, un reste alkyle de 1 à 8 atomes de carbone ou un reste aryle ou aralkyle éventuellement substitué, et, comme composé à effet réticulant, un composé ayant au moins deux groupes réactifs qui, sous l'influence de la chaleur, peuvent réagir avec des groupes —COOH— en formant une liaison chimique covalente, après quoi on durcit et réticule thermiquement, de façon sélective, les zones exposées de la couche-réserve et ensuite on élimine, avec un solvant révélateur, les zones non réticulées de la couche-réserve, caractérisé par le fait qu'après l'exposition selon l'image et le durcissement-réticulation thermique sélectif de la zone exposée, on

réexpose encore une fois à la lumière actinique toute la surface et on lave avec un solvant révélateur aqueux.

2. Procédé selon la revendication 1, caractérisé par le fait que la couche-réserve, sensible à la lumière, contient un composé possédant des groupements ester d'o-nitrocarbinol de formule générale (I), dans lequel le carbinol servant de base aux groupements ester d'o-nitrocarbinol de formule I est l'alcool o-nitrobenzylique, 2-nitro-6-chlorobenzylique, 2-nitro-2-4-cyanobenzylique, 2-nitro-4,5-diméthoxybenzylique, α-méthyl-o-nitrobenzylique, α-phényl-o-nitrobenzylique ou α-(o-nitrophényl)-o-nitrobenzylique.

3. Procédé selon les revendications 1 et 2, caractérisé par le fait que la couche-réserve, sensible à la lumière, contient, comme composé à groupement ester d'o-nitrocarbinol de formule (I), un di- et/ou polyester, un di- et/ou polyacide carboxylique à bas poids moléculaire ainsi qu'un liant polymère compatible avec cet ester.

4. Procédé selon les revendications 1 et 2, caractérisé par le fait que la couche-réserve, sensible à la lumière, contient un polymère d'un poids moléculaire supérieur à 500, qui contient, lié à la molécule, au moins 5 % en poids, rapportés au poids moléculaire du polymère, de groupements ester d'o-nitrocarbinol aromatiques et/ou hétéro-aromatiques, de formule (I).

5. Procédé selon la revendication 4, caractérisé par le fait que la couche-réserve, sensible à la lumière contient un polymère portant des groupements ester d'o-nitrocarbinol de formule (I), qui dérive d'un homo- ou copolymérisat de l'acide acrylique, méthacrylique, maléique, fumarique et/ou crotonique.

6. Procédé selon l'une des revendications 1 à 5, caractérisé par le fait que la couche-réserve, sensible à la lumière, contient un composé, en particulier un polymère, qui, outre les groupements ester de o-nitrocarbinol, de formule (I), contient, en même temps, incorporés dans la molécule, les groupes réactifs vis-à-vis des groupes —COOH, agissant comme réticulants.

7. Procédé selon la revendication 6, caractérisé par le fait que le composé, contenant les groupements ester de o-nitrocarbinol de formule (I), contient, en outre, incorporés, des groupes amine, imine, amide, époxyde, hydroxy, isocyanate et/ou isocyanate masqué.

8. Procédé selon l'une des revendications 1 à 5, caractérisé par le fait que la couche-réserve, sensible à la lumière, outre le composé à groupements ester de o-nitrocarbinol de formule (I), contient en plus un ou plusieurs composés à effet réticulant ayant au moins deux groupes réactifs du type indiqué.

9. Procédé selon la revendication 8, caractérisé par le fait que la couche-réserve, sensible à la lumière, contient, comme composé à effet réticulant, des époxydes, isocyanates, isocyanates masqués, α,ω-diisocyanatopolycarbodimides, alcools et/ou amines.

10. Procédé selon l'une des revendications 1 à 9, caractérisé par le fait que la couche-réserve, sensible à la lumière, contient, comme autres additifs, des plastifiants, agents d'étalement, catalyseurs pour le durcissement thermique, sensibilisateurs, colorants, pigments et/ou substances photochromes.

11. Procédé selon l'une des revendications 1 à 10, caractérisé par le fait que le durcissement-réticulation thermique de la couche-réserve exposée selon l'image est effectué à des températures de la zone allant de 50 à 250 °C.

12. Procédé selon l'une des revendications 1 à 11, caractérisé par le fait qu'après le lavage au solvant révélateur aqueux, on procède encore à une nouvelle réticulation-durcissement thermique.

13. Procédé selon l'une des revendications 1 à 12, caractérisé par le fait que la couche-réserve, solide, sensible à la lumière, a été appliquée, par laminage, sur le support en utilisant la pression et/ou de la chaleur.

14. Procédé selon la revendication 13, caractérisé par le fait que la couche-réserve, sensible à la lumière, avant d'être appliquée par laminage sur le support, a été soumise, pendant un court moment, sur toute la surface de son côté tourné vers le support, à une pré-exposition à la lumière actinique.

15. Utilisation du procédé selon l'une des revendications 1 à 14 dans la technique des semiconducteurs, pour la fabrication de pistes conductrices, de circuits intégrés ou imprimés ou de masques d'arrêt à soudure.

16. Utilisation du procédé selon l'une des revendications 1 à 14 pour la fabrication de plaques offset.